# EUROPÄISCHE PATENTANMELDUNG

(11) **EP 0 564 819 A2**
(43) Veröffentlichungstag der Anmeldung: **13.10.1993**
(21) Anmeldenummer: 93103513.3
(22) Anmeldetag: 05.03.1993
(51) Int. Cl.: C23C 14/06, C23C 14/14, C23C 14/32

(54) **Verfahren zur Abscheidung haftfester metallischer oder keramischer Schichten sowie haftfester Kohlenstoffschichten auf temperaturempfindlichen Materialien**

(30) Priorität: 09.04.1992 DE 4211956
(71) Anmelder: METAPLAS IONON Oberflächenveredelungstechnik GmbH, D-51427 Bergisch Gladbach (DE)
(72) Erfinder: Vetter, Jörg, Dr. rer. nat., W-5060 Bergisch-Gladbach 2 (DE); Rother, Bernd, Dr. rer. nat., O-9051 Chemnitz (DE); Kühn, Michael, Dipl.-Phys., O-9033 Chemnitz (DE); Schmidtbauer, Sven, O-8354 Lohmen (DE)
(74) Vertreter: Stenger, Watzke & Ring Patentanwälte

(57) **Zusammenfassung**

Die Erfindung betrifft ein Verfahren zur Abscheidung haftfester metallischer oder keramischer Schichten sowie haftfester Kohlenstoffschichten auf temperaturempfindlichen Materialien mittels einer kathodischen Vakuumbogenverdampfung. In einem Einstufenprozeß wird der Anfangsdruck der kathodischen Vakuumbogenbeschichtung so eingestellt, daß die mittlere freie Weglänge für den Transport der Ionen des Kathodenmaterials zum Substrat größer als die Hälfte des Abstandes von der Kathode zum Substrat ist. Im weiteren Verlauf der Beschichtung wird der Druck auf Werte erhöht, welche einer mittleren freien Weglänge von weniger als dem halben Abstand zwischen der Kathode und dem Substrat entsprechen.

## Beschreibung

Die Erfindung bezieht sich auf die Beschichtung temperaturempfindlicher Substrate mittels der kathodischen Vakuumbogenverdampfung und ist vor allem für Metallisierungsaufgaben von Kunststoffteilen einschließlich Folien und für die Abscheidung keramischer Schutzschichten auf Kunststoffteilen anwendbar.

Die Abscheidung haftfester metallischer oder keramischer Schichten sowie haftfester Kohlenstoffschichten auf temperaturempfindlichen Substraten wird gegenwärtig mit Hilfe einer Reihe aufeinanderfolgender Verfahrensschritte realisiert. Die einzelnen Verfahrensschritte zielen dabei einerseits auf eine definierte Oberflächenaktivierung der zu beschichtenden Materialien sowie auf das Aufbringen einer haftvermittelnden Schicht, ohne den Grundwerkstoff dabei zu zerstören; andererseits sollen sie das schnelle Aufwachsen eines dem jeweiligen Verwendungszweck angepaßten Schichtsystems gewährleisten. Prinzipiell sind für diese Verfahrenskomplexe sowohl galvanische als auch vakuumgestützte Beschichtungsverfahren bzw. Kombinationen aus beiden geeignet. Höhere Haftfestigkeiten werden allerdings mittels vakuumgestützter Verfahren erzielt. In jedem Fall muß aber mit speziellen Substratvorbehandlungen oder mit mehreren Beschichtungsschritten gearbeitet werden.

Das Aufbringen von lötfähigen Kupferschichten auf Polymerfolien wird beispielsweise in WO 89/4880 als Verfahrenskomplex aus Trocken- oder Naßanätzen der Folienoberfläche, anschließendes Aufbringen einer Ni-Cr Zwischenschicht und darauffolgendes Vakuumbedampfen mit Kupfer beschrieben. Nach WO 86/2387 sind zum Aufbringen von Zinnschichten auf Polymerfolien besonders mit Titanhydrid vorbehandelte Folienoberflächen geeignet. Schließlich wird in der EP-PS 187 706 eine Erwärmung des Substratmaterials auf Temperaturen zwischen 60 % und 80 % der Zersetzungstemperatur des Grundmaterials sowie eine Bedampfungsrate des Metalles vorgeschlagen, welche identisch mit der Diffusionsrate der abzuscheidenden Metalle in das erwärmte Substratmaterial ist.

Für die Bedampfung von Polykarbonatteilen werden in der DE-PS 38 00 144 Zwischenschichten aus Kupfer und Zinn-Aluminiumlegierungen beschrieben. Für die Beschichtung ebenfalls temperaturempfindlicher Zellulosefasern wird zur Oberflächenaktivierung und damit zur Haftvermittlung in WO 85/2205 eine Silanbehandlung vorgeschlagen.

Neben temperaturempfindlichen organischen Substanzen werden auch eine Reihe temperaturempfindlicher anorganischer Materialien durch Bedampfen mit Metallisierungsschichten versehen. Entsprechend der DD-PS 26 49 43 und DD-PS 27 66 97 sind auch hierfür Mehrfachschichtsysteme notwendig.

Insgesamt ergibt sich aus der Literatur für die vakuumgestützte Beschichtung temperaturempfindlicher Grundmaterialien, daß grundsätzlich eine Vielzahl von Vorbehandlungs- und Zwischenschritten bis zum endgültigen Aufbringen der abschließenden Funktionsschicht notwendig ist. Naßchemische Behandlungsschritte erfordern darüber hinaus eine zusätzliche technologische Anpassung an die Vakuumbeschichtung.

Der Erfindung liegt die **Aufgabe** zugrunde, ein technologisch einfaches und kostengünstiges Verfahren zur Beschichtung temperaturempfindlicher organischer und anorganischer Substanzen, wie z.B. von Kunststoffen und Piezokeramiken, mit metallischen oder keramischen Materialien, aber auch mit Kohlenstoff unter Anwendung von haftfestigkeitsfördernden hohen Ionisierungsgraden des unter Vakuumbedingungen zur Abscheidung gelangenden Materials zu schaffen.

Diese Aufgabe wird mit der Erfindung dadurch gelöst, daß bei der in einem Einstufenprozeß durchgeführten kathodischen Vakuumbogenverdampfung der Anfangsdruck so eingestellt wird, daß die mittlere freie Weglänge für den Transport der Ionen des Kathodenmaterials zum Substrat größer als die Hälfte des Abstandes von der Kathode zum Substrat ist, und daß der Druck im weiteren Verlauf der Beschichtung auf Werte erhöht wird, welche einer mittleren freien Weglänge von weniger als dem halben Abstand zwischen der Kathode und dem Substrat entsprechen.

Die Erosionsprodukte der kathodischen Vakuumbogenverdampfung setzen sich aus Neutraldampf, Ionen und makroskopischen Splittern oder Tröpfchen zusammen, wobei die Ionenkomponente einen materialabhängigen Anteil an den atomaren Erosionsprodukten von 10 bis 90 % hat. Gleichzeitig besitzt die Ionenkomponente eine von der Kathode weg gerichtete Geschwindigkeit, welche einem jeweils materialspezifischen Energieäquivalent von 20 bis 70 eV entspricht.

Der hohe Ionisierungsgrad des zur Abscheidung gelangenden Materials sowie die hohe Eigenenergie der Ionenkomponente bewirken die Ausbildung einer guten Haftfestigkeit der aufwachsenden Schicht selbst auf elektrisch isolierenden bzw. auf elektrisch nicht vorgespannten Substratmaterialien. Zur Verbesserung der Haftfestigkeit kann gemäß einem weiteren Merkmal der Erfindung die Ionenenergie zusätzlich durch das Anlegen elektrischer Gleich- oder Wechselfelder an die Substrate vergrößert werden.

Die für das Verfahren typischen Substratstromdichten von mehr als 1 mA cm⁻² würden allerdings im weiteren Verlauf der Beschichtung zu einem starken Leistungseintrag in den sich ausbildenden Schicht-Substratverbund führen, so daß selbst bei elektrisch nicht und thermisch gut kontaktierten Unterlagen eine Überhitzung des Grundmaterials auftreten würde.

Durch Gaseinlaß in den Transportraum und eine damit verbundene Druckerhöhung wird gemäß der Erfindung eine druckabhängige Thermalisierung des hochenergetischen Ionenstromes erzielt, was zu einer reduzierten thermischen Belastung des Substratmaterials führt. Hierbei hat sich gezeigt, daß die mittlere freie Weglänge der von der Kathode zum Substrat strömenden Ionen im Verhältnis zum Abstand zwischen der Kathode und dem Substrat das bestimmende Kriterium der Thermalisierung ist. Sei mittleren freien Weglängen von mehr als der Hälfte des Abstandes zwischen Kathode und Substrat gelangt ein für die Ausbildung haftfester Schichten noch genügend hoher Anteil hochenergetischer Ionen auf das Substrat, während bei mittleren freien Weglängen von weniger als der Hälfte der Transportraumlänge, insbesondere aber von weniger als einem Zehntel der Transportraumlänge eine bereits spürbare Thermalisierung bei gleichzeitiger Verringerung der Ionenstromdichte einsetzt.

Als Möglichkeit zur Druckerhöhung im Transportraum sind neben dem direkten Gaseinlaß auch eine zusätzliche Drosselung der Pumpleistung oder eine Mehrkammeranordnung mit verschiedenen Kammerdrücken geeignet. Je nach Beschichtungsziel können sowohl inerte als auch reaktive Gase zur Druckerhöhung eingesetzt werden, wodurch die Abscheidung sowohl metallischer als auch keramischer Schichten möglich wird. Beim Einsatz von Graphitkathoden kann das Verfahren auch zur Abscheidung von Kohlenstoffschichten genutzt werden.

Das erfindungsgemäße Verfahren zur Abscheidung haftfester metallischer oder keramischer Schichten sowie haftfester Kohlenstoffschichten auf temperaturempfindlichen Materialien kann besonders vorteilhaft zum Aufbringen von für nachfolgende Galvanisierungsschritte geeignete Kupferschichten auf Kunststoff-Folien oder auf faserverstärkten Kunststoffen eingesetzt werden. Die Abscheidung funktioneller oder dekorativer keramischer Schutzschichten auf Kunststoffmaterialien ist ein weiteres bevorzugtes Anwendungsgebiet.

Drei Ausführungsbeispiele sollen das erfindungsgemäße Verfahren im folgenden näher erläutern.

In einem ersten Beispiel werden in einer Anlage zur kathodischen Vakuumbogenverdampfung scheibenförmige und 5 mm dicke Bauteile aus PVC derartig befestigt, daß sie sich über eine ihrer Stirnflächen in ständigem Kontakt zu einem wassergekühlten und elektrisch nicht kontaktierten Substrathalter befinden. Die nicht kontaktierte Stirnseite der Bauteile befindet sich dabei in einem Abstand von 20 cm von der zu erodierenden Kupferkathode und ist dieser direkt zugewandt. Die Anlage wird anschließend bis auf einen Restgasdruck von 5 X 10⁻⁶ Torr evakuiert. Nach dem Zuschalten der Substratkühlung und einer fünfminütigen Kühlzeit erfolgt das Zünden der Entladung, welche im weiteren Verlauf bei einem Bogenstrom von 80 A betrieben wird. 10 Sekunden nach dem Zünden der Entladung wird Argon bis zum Erreichen eines Druckes von 10⁻² Torr in den Rezipienten eingelassen, wobei die Zeit der Druckerhöhung 10 Sekunden beträgt.

Unter den genannten Abscheidebedingungen wächst auf den der Kathode zugewandten Stirnflächen der Substrate eine Kupferschicht mit einer Aufwachsrate von 50 mm min⁻¹ auf. Die Beschichtung wird nach 30 Minuten Beschichtungsdauer abgebrochen. Zu diesem Zeitpunkt ist eine dichte und haftfeste Kupferschicht auf einer Stirnseite der Bauteile aufgebracht, ohne daß dabei das temperaturempfindliche PVC thermisch überlastet wurde.

In einem zweiten Beispiel werden in einer Vakuumbeschichtungsapparatur mit einer angeflanschten Quelle zur Vakuumbogenbeschichtung Epoxydharzplättchen mit einer Dicke von 3 mm und einer Ausdehnung von 2 X 3 cm² derartig zur Beschichtung positioniert, daß sie sich in ständigem Kontakt zu einer wassergekühlten und elektrisch vorspannbaren Fläche befinden. Der Abstand zu der zu erodierenden Titaniumkathode beträgt dabei 30 cm. Die Apparatur wird anschließend mittels einer Öldiffusionspumpe auf einen Druck von 5 X 10⁻⁰ Torr evakuiert.

Die Beschichtung der Substrate beginnt unmittelbar mit dem Zünden der Entladung bei einer Substratvorspannung von -100 V und wird mit einem Bogenstrom von 100 A betrieben. 10 Sekunden nach dem Zünden der Entladung wird die Substratvorspannung auf -10 V erniedrigt und gleichzeitig Stickstoff bis zu einem Arbeitsdruck von 10⁻³ Torr in den Beschichtungsraum eingelassen. Die Beschichtung wird unter Beibehaltung der angegebenen Parameter über einen Zeitraum von 5 Minuten betrieben. Nach einer Abkühlzeit von 10 Minuten erfolgt die Belüftung der Beschichtungskammer.

In einem letzten Beispiel wird Folienmaterial aus Polyethylen in einer Beschichtungsapparatur zur Vakuumbogenverdampfung derartig positioniert, daß es sich in ständigem Kontakt mit einer wassergekühlten Fläche befindet und der Abstand zu der zu erodierenden Graphitkathode 30 cm beträgt. Zwischen der Folie und der Kathode befindet sich eine schwenkbare Blende. Die Beschichtungsapparatur wird bis auf einen Druck von 5 X 10⁻⁰ Torr evakuiert. Vor dem Zünden der Entladung wird ein HF-Signal mit einer Amplitude von 200 V und einer Frequenz von 3,8 MHz an die metallische Kühlfläche für die zu beschichtenden Folien angelegt. Das Zünden der Entladung erfolgt bei geschlossener Blende.

Während der ersten 5 Minuten der Entladung erfolgt ein Ausgasen der Kathode, wodurch der Druck im Beschichtungsraum kurzzeitig auf Werte um 10⁻⁴ Torr ansteigt. Nach 5 Minuten Brenndauer ist der Druck auf 10⁻⁵ Torr abgesunken und die Blende kann geöffnet werden. Die Beschichtungszeit bei diesem Druck beträgt 20 Sekunden. Durch den Einlaß von Argon wird der Druck in der Arbeitskammer der Beschichtungsapparatur anschließend auf 10⁻³ Torr erhöht und die Folien 10 Minuten beschichtet.

Bei allen diesen erfindungsgemäßen Verfahren wird somit zu Beginn des Einstufenprozesses ein Beschuß der Substrate mit hoher Energie die Ionen bewirkt, um eine gute Haftung der aufzubringenden Beschichtung zu gewährleisten. Danach wird zur Vermeidung einer unzulässigen Temperaturbelastung der empfindlichen Substrate die Energie der Ionen dadurch reduziert, daß die Zahl der vorhandenen Gasatome im Behandlungsraum erhöht wird, so daß die Ionen auf ihrem Weg von der Kathode zu den Substraten häufiger auf Gasatome treffen, wodurch sie einen Teil ihrer Energie verlieren. Auf diese Weise wird trotz der Anwendung eines einstufigen Verfahrens einerseits eine thermische Überbeanspruchung der temperaturempfindlichen Substrate verhindert und andererseits wegen der hohen Energiedichte zu Beginn des Beschichtungsprozesses eine gute Haftfestigkeit der Beschichtung erreicht.

## Patentansprüche

1. Verfahren zur Abscheidung haftfester metallischer oder keramischer Schichten sowie haftfester Kohlenstoffschichten auf temperaturempfindlichen Materialien mittels kathodischer Vakuumbogenverdampfung, dadurch gekennzeichnet, daß bei der in einem Einstufenprozeß durchgeführten kathodischen Vakuumbogenverdampfung der Anfangsdruck so eingestellt wird, daß die mittlere freie Weglänge für den Transport der Ionen des Kathodenmaterials zum Substrat größer als die Hälfte des Abstandes von der Kathode zum Substrat ist, und daß der Druck im weiteren Verlauf der Beschichtung auf Werte erhöht wird, welche einer mittleren freien Weglänge von weniger als dem halben Abstand zwischen der Kathode und dem Substrat entsprechen.

2. Verfahren nach Anspruch 1, dadurch gekennzeichnet, daß der Druck im Verlaufe der Beschichtung auf Werte erhöht wird, welche einer mittleren freien Weglänge für den Transport der Ionen von der Kathode zum Substrat von weniger als einem Zehntel des Abstandes zwischen Kathode und Substrat entsprechen.

3. Verfahren nach Anspruch 1, dadurch gekennzeichnet, daß das zu beschichtende Substrat bei Prozeßbeginn zumindest kurzzeitig elektrisch vorgespannt wird.

4. Verfahren nach den Ansprüchen 1 und 3, dadurch gekennzeichnet, daß bei der Verdampfung von Metallen und bei einem Abstand zwischen Kathode und Substrat von mehr als 20 cm und weniger als 50 cm der Gasdruck im Beschichtungsraum unmittelbar nach Beginn der Beschichtung von 10⁻⁶ Torr durch Gaszugabe auf 10⁻² Torr erhöht wird.
